# FASCICULE DE BREVET EUROPEEN

(11) **EP 3 918 667 B1**
(45) Date de publication et mention de la délivrance du brevet: **20.12.2023**
(21) Numéro de dépôt: 20701482.0
(22) Date de dépôt: 28.01.2020
(51) Int. Cl.: H01Q 7/00, H01R 12/78, H05K 1/02, H01Q 1/38, H05K 1/11

(54) **ANTENNE DE COMMUNICATION SANS CONTACT POUR TERMINAL DE COMMUNICATION**
KONTAKTLOSE KOMMUNIKATIONSANTENNE FÜR KOMMUNIKATIONSENDGERÄT
CONTACTLESS COMMUNICATION ANTENNA FOR COMMUNICATION TERMINAL

(30) Priorité: 29.01.2019 FR 1900781
(43) Date de publication de la demande: 08.12.2021
(73) Titulaire: Banks and Acquirers International Holding, 75015 Paris (FR)
(72) Inventeur: HERNANDEZ, Vincent, 26240 Claveyson (FR); ANDRE, Jérôme, 26800 Montoison (FR)
(74) Mandataire: LLR
(86) Numéro de dépôt international: PCT/EP2020/052070
(87) Numéro de publication internationale: WO 2020/157082

(56) Documents cités:
- EP-A1- 3 107 149
- EP-A2- 3 300 260
- WO-A1-2018/033748
- FR-A1- 3 065 119
- US-A1- 2010 190 528
- US-A1- 2018 317 324
- US-B2- 9 226 393

## Description

### 1. Domaine de l'invention

L'invention se rapporte au domaine des antennes de communication. L'invention se rapporte plus particulièrement au domaine des antennes de communication pour dispositif portables, tels que des terminaux d'utilisateur ou des terminaux de paiement.

### 2. Art Antérieur

Les terminaux d'utilisateurs, tels que des smartphones, des tablettes mais également des terminaux de paiements intègrent différentes techniques de réception et de transmission de données sans fil : UMTS, GSM, WIFI, Bluetooth, NFC. Ces techniques nécessitent la mise en oeuvre d'émetteurs/récepteurs et d'antennes. Les émetteurs/récepteurs se présentent souvent sous la forme de puces qui prennent place sur un circuit imprimé (également appelé PCB de l'anglais pour « *printed circuit board* »)*.* Certaines puces émetteurs/récepteurs sont multistandards. Cela signifie qu'elles prennent en charge plusieurs techniques de transmission de données. Pour pouvoir fonctionner correctement, une puce émetteur/récepteur est notamment connectée à une antenne. L'antenne est un dispositif permettant de rayonner (émetteur) ou, de capter (récepteur), les ondes électromagnétiques.

L'une des techniques les plus récemment intégrée au sein de terminaux d'utilisateur est une technique de lecture sans contact. Il s'agit par exemple d'une technique de communication en champ proche (CCP) appelée NFC (de l'anglais pour *« near field communication* »)*.* La communication en champ proche (CCP) est une technologie de communication sans fil à courte portée et haute fréquence qui permet d'échanger des données entre deux dispositifs compatibles à une distance maximum de l'ordre de la dizaine de centimètres. Il s'agit d'une extension de connexion de la norme qui définit les cartes de proximité utilisant la radio-identification (RFID de l'anglais « *radio frequency identification »*), qui combinent l'interface d'une carte à puce et un lecteur au sein d'un seul périphérique.

La mise en oeuvre de cette technique de transmission de données au sein des terminaux n'est pas sans poser quelques problèmes, notamment des problèmes d'intégration, du fait de la miniaturisation des dispositifs et de la réduction de l'espace disponible pour réaliser cette intégration. D'autres contraintes sont également présentes, comme des concurrences entre fonctions de communication sans fils (des bandes de fréquence peuvent être proches, pour certaines de ces fonctions, et les modules d'émission et de réception de données peuvent recevoir des perturbations en provenance des autres modules de communications). Par exemple, un terminal de paiement intègre de nombreux modules de lecture de carte de de paiement : cartes à puces, cartes à pistes et dispositifs sans contact (cartes, terminaux de type smartphone).

Ainsi, pour la lecture de carte de paiement sans contact, il est nécessaire que le terminal de paiement soit équipé d'une antenne de communication sans contact. Compte tenu des contraintes d'intégration, de compacité et d'ergonomie, l'antenne sans contact du terminal est habituellement située au niveau du logement de l'imprimante ou autour de l'écran du terminal de paiement. Par ailleurs, dans le cadre d'un terminal de paiement, il faut que la transaction de paiement soit menée dans un laps de temps prédéterminé. Il est donc nécessaire que l'antenne sans contact permette une lecture claire (c'est-à-dire le moins parasitée possible) et rapide des données en provenance d'une carte de paiement sans contact. C'est l'une des contraintes principales qui est à la base de la réalisation de l'antenne sans contact et de son intégration au sein du terminal de paiement. A l'inverse, pour un smartphone, l'antenne sans contact est généralement située au dos du terminal. Les contraintes de réalisation et d'intégration à cet endroit sont les mêmes que dans le terminal de paiement.

Ainsi, dans le cas d'un système de communication sans contact dont l'antenne est située autour de l'écran du terminal de paiement, lorsque l'utilisateur souhaite effectuer un paiement à l'aide de sa carte sans contact ou de son smartphone, il approche celui-ci de l'écran. Les concepteurs de terminaux de paiement ont en effet jugé que l'antenne nécessaire au paiement sans contact (antenne contactless), devait être placée en face ou à proximité de l'endroit où l'utilisateur présente son moyen de paiement.

De plus, dans la mesure où le montage d'un terminal de paiement est une opération complexe, réalisé pour une bonne partie à la main, les concepteurs de terminaux doivent prendre en compte cet aspect lorsqu'ils conçoivent un nouveau terminal. L'adjonction d'une antenne sans contact, qui doit nécessairement être proche de la surface externe du terminal (pour que le rayonnement de l'antenne soit efficace), a donc été réalisée de la manière la plus simple possible tant en termes de montage qu'en termes de positionnement.

Pour ce faire, pour les terminaux les plus récents, l'antenne sans contact est réalisée sous la forme d'un circuit imprimé flexible qui fait le tour de l'écran. Cette méthode de conception de l'antenne sans contact est avantageuse d'un certain point de vue. En effet, le montage de cette antenne est extrêmement simple. Il suffit de poser l'antenne autour de l'écran et de brancher le flexible dans un connecteur préalablement soudé sur la carte mère du terminal (connecteur FPC).

Cette méthode de conception de l'antenne sans contact pose cependant un problème économique. En effet, les circuits imprimés flexibles sont facturés lors de leur fabrication en fonction de la surface totale occupée par le circuit imprimé flexible. Autrement dit, comme l'antenne sans contact effectue le tour de l'écran, une partie substantielle de la surface de ce circuit imprimé flexible est facturée (le centre, qui est vide) alors même qu'elle n'est pas utilisée. On peut aisément comprendre que lorsque la taille d'un écran est par exemple de 12 cm², le fait de devoir payer un circuit imprimé flexible pour 12 cm² alors que seulement une infime partie de cette surface est réellement utilisée dans la fabrication du terminal pose un problème sensible au niveau du coût de fabrication du terminal.

Le brevet européen EP3107149 décrit une solution à ce problème. Plus particulièrement, il y est décrit un circuit imprimé flexible de forme longitudinale, comprenant au moins une piste conductrice s'étendant sur la longueur du circuit imprimé flexible, le circuit imprimé flexible comprenant au moins une zone de pliage conformée pour autoriser le passage dudit circuit imprimé flexible d'un état déplié à un état plié dans lequel la piste conductrice forme au moins une boucle d'antenne. Pour fonctionner, cette solution nécessite une opération de soudure au niveau de zones de superposition du circuit imprimé, lorsque celui-ci est plié pour former l'antenne. Or, une telle opération de soudure est d'une part complexe à réaliser et d'autre part couteuse : elle nécessite la mise en oeuvre d'une opération de soudure (manuelle ou automatique) et l'utilisation de matériaux résistants à la soudure (pour le circuit imprimé flexible).

Il est donc nécessaire de disposer d'une solution de fabrication et de montage d'une antenne qui ne pose pas ces problèmes de l'art antérieur. Les documents EP 3 300 260 A2, US 2018/317324 A1 et WO 2018/033748 A1 divulguent circuits imprimés flexibles similaires.

### 3. Résumé

La présente divulgation permet de résoudre au moins certains des problèmes posés par les antennes de communication sans contact de l'art antérieur. La présente divulgation se rapporte plus particulièrement à un circuit imprimé flexible, comprenant au moins deux pistes conductrices s'étendant sur la longueur du circuit imprimé flexible, circuit imprimé flexible dans lequel les pistes conductrices forment au moins deux boucles d'antenne, lesdites au moins deux pistes conductrices étant sensiblement parallèles entre elles.

Selon l'invention, un tel circuit imprimé flexible comprend une zone de contact située à une première extrémité du circuit imprimé flexible et configurée pour entrer en contact avec une portion prédéterminée dudit circuit imprimé flexible, de sorte qu'une première piste du circuit imprimé flexible soit connectée avec une deuxième piste du circuit imprimé flexible lorsque la première extrémité est mise au contact de la portion prédéterminée.

Selon l'invention, un tel circuit imprimé flexible comprend au plus deux extrémités et en ce qu'au moins une de ces deux est destinée à être insérée dans un connecteur.

Ainsi, il est possible grâce à l'invention de ne pas faire appel à une soudure, comme dans l'art antérieur, pour souder deux extrémités du circuit imprimé flexible.

Selon l'invention, la portion prédéterminée est constituée de la deuxième extrémité dudit circuit imprimé.

Il est ainsi possible de faire en sorte que les pistes de circuit imprimé, une fois recouvertes les unes sur les autres au niveau des extrémités, soient utilisées pour matérialiser les spires d'une antenne multispires.

Selon l'invention, la mise au contact de la première extrémité avec la deuxième extrémité est effectuée lors de la connexion des deux extrémités au sein d'un connecteur.

Ainsi, la mise en oeuvre de l'antenne est simple : son positionnement et son insertion dans le terminal sont facilitées.

Selon l'invention, le circuit imprimé flexible comprend au moins une zone de pliage conformée pour autoriser le passage dudit circuit imprimé flexible d'un état déplié à un état plié.

Selon l'invention, la zone de contact comprend des moyens de connexion des dites au moins deux pistes conductrices entre elles afin de former un nombre prédéfini de boucles d'antenne.

Selon l'invention, le circuit imprimé flexible comprend au moins un orifice de fixation dudit circuit imprimé flexible sur au moins un support d'antenne.

Ainsi, il est possible de disposer d'une antenne simple et économique à réaliser, tout en permettant de disposer celle-ci dans un espace tridimensionnel plutôt qu'à plat comme cela peut être le cas traditionnellement.

Selon un autre aspect, l'invention se rapporte également à un dispositif comprenant des moyens de communication sans fil mettant en oeuvre un émetteur transmetteur et une antenne. Selon un mode de réalisation particulier, ladite antenne comprend un circuit imprimé flexible tel que précédemment décrit.

Selon un mode de réalisation particulier, le dispositif comprend un connecteur au sein duquel les deux extrémités du circuit imprimé sont insérées de sorte que la première extrémité est mise au contact de la deuxième extrémité lors de l'insertion des deux extrémités dans ledit connecteur.

Selon un mode de réalisation particulier, le connecteur est de type top-bottom.

### 4. Dessins

D'autres caractéristiques et avantages apparaîtront plus clairement à la lecture de la description suivante d'un mode de réalisation particulier de la divulgation, donné à titre de simple exemple illustratif et non limitatif, et des dessins annexés, parmi lesquels :

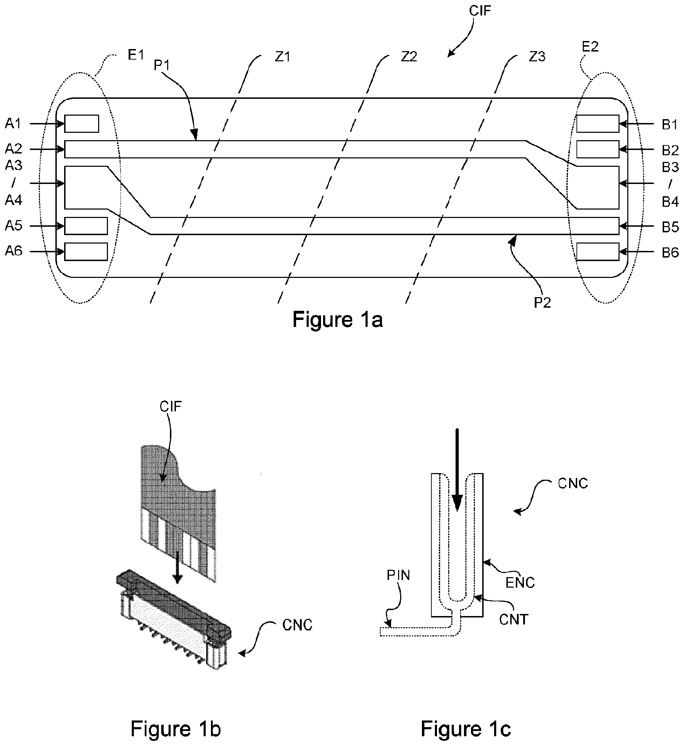

- la figure1a illustre le principe général du circuit imprimé flexible de l'invention ;
- la figure1b illustre un connecteur destiné à recevoir le circuit imprimé flexible ;
- la figure1cillustre une coupe de connecteur destiné à permettre le contact de deux extrémités
- la figure2a illustre un mode de réalisation d'une première extrémité du circuit imprimé flexible ;
- la figure2b illustre un mode de réalisation d'une deuxième extrémité du circuit imprimé flexible ;
- la figure2c est une vue en trois dimensions de la jonction faite entre les deux extrémités du circuit imprimé flexible des figures 2a et 2b ;
- la figure3 illustre un autres mode de réalisation d'un circuit imprimé flexible ;
- la figure4a illustre un autre mode de réalisation d'un circuit imprimé flexible, dans lequel les pistes de circuit imprimé sont inscrites sur les deux faces circuit imprimé flexible ;
- la figure4b illustre une antenne comprenant un circuit imprimé flexible double face tel que décrit en figure 4a ;
- la figure4c illustre une antenne comprenant un circuit imprimé flexible double face tel que décrit en figure 4a dans un autre mode de réalisation.

### 5. Exposé

Comme explicité préalablement, la solution proposée consiste à réaliser une antenne en circuit imprimé flexible. Pour réduire les coûts de fabrication par rapport aux antennes antérieures, également réalisée en circuit imprimé flexible, une première caractéristique de la technique proposée consiste à concevoir un circuit imprimé flexible comprenant au moins deux pistes d'antennes. Selon l'invention, prise individuellement, chaque piste du circuit imprimé constitue une boucle d'antenne. A la différence de la technique antérieure, notamment celle du brevet européen EP3107149, les pistes du circuit imprimé flexible de l'invention sont connectées entre elles pour former une antenne multi-spires lors de l'insertion d'une extrémité au moins du circuit imprimé dans un connecteur idoine. Comme cela est explicité ci-après en lien avec plusieurs modes de réalisation, le circuit imprimé flexible et le connecteur sont adaptés de sorte que les boucles d'antennes soient effectivement formées par la connexion du circuit imprimé dans le connecteur. Plus particulièrement, le connecteur peut être un connecteur standard du commerce utilisé adroitement pour provoquer, lors du branchement du circuit imprimé dans le connecteur, la création des spires de l'antenne.

La figure 1a explicite le principe général de l'invention. Comme indiqué sur ce schéma de principe, deux pistes de circuit imprimé (P1, P2) sont formées sur le circuit imprimé flexible (CIF) de l'invention. Ces deux pistes sont indépendantes les unes des autres et sensiblement parallèles. Au moins une extrémité (E1, E2), le circuit imprimé flexible (CIF) est conformé de sorte que les pistes électriques qui y sont inscrites se trouvent connectées lors de l'insertion du circuit imprimé flexible dans le connecteur idoine (CNC, figure 1b, figure 1c). Plus particulièrement, dans l'exemple de la figure 1A, l'antenne est formée de deux spires, les deux spires étant matérialisées lors de l'insertion des deux extrémités (E1, E2) du circuit imprimé flexible (CIF) dans le même connecteur, au niveau des zones de contact A3/A4 et B3/B4. Le circuit imprimé flexible (CIF) est recourbé sur lui-même (par l'intermédiaire de pliages), afin de se conformer à un volume attendu au sein duquel il doit prendre place pour jouer le rôle d'antenne. Une fois ce pliage réalisé, les deux extrémités du circuit imprimé flexible sont insérées en même temps dans le connecteur (CNC).

La figure 1b illustre le connecteur (CNC) dans lequel le circuit imprimé flexible (CIF) de la figure 1a prend place. Le connecteur CNC est lui-même solidarisée avec un circuit imprimé (par exemple une carte mère, non représenté). Dans ce mode de réalisation seuls les pattes numéro 2 et 5 du connecteur (CNC) sont effectivement reliées par circuit à un composant d'émission/réception de signal. Les autres pattes du connecteur ne sont pas utilisées (autrement que pour assurer la fixation du connecteur sur le circuit imprimé (la carte mère)). La figure 1c représente une coupe du connecteur (CNC). Il comprend une enceinte (ENC), généralement en plastique et une pluralité de lames métalliques (une seule représentée en pointillés sur cette coupe), la lame métallique comprenant une portion de connexion (CNT) et une patte de fixation (PIN) destinée à être fixée. Dans ce mode de réalisation, la portion de connexion est double (gauche/droite sur la figure) assurant ainsi une connexion entre les zones de contact A3/A4 et B3/B4.

L'invention, consiste ainsi, en résumé, en un circuit imprimé flexible dont les pistes forment une antenne lorsqu'elles sont connectées au sein d'un connecteur, le connecteur étant sélectionné pour permettre un contact entre deux pistes différentes du circuit imprimé flexible. Selon l'invention, le circuit imprimé flexible, quant à lui, dispose d'au moins une piste (parmi l'ensemble des pistes ayant pour fonction une spire d'antenne) dont la largeur, à l'extrémité, occupe au moins deux emplacements au sein du connecteur.

Selon l'invention, il suffit d'un connecteur ayant au moins un contact de plus que le nombre de spires à réaliser pour permettre un décalage de boucle (par exemple trois contacts pour deux spires, comme exposé précédemment, quatre contacts pour trois spires, etc.). Cependant, dans un souci d'efficacité économique, les connecteurs du commerce sont utilisés. Ceux-ci comprennent généralement un nombre pair de pattes de connexion et ces connecteurs sont préférés pour une mise en oeuvre opérationnelle.

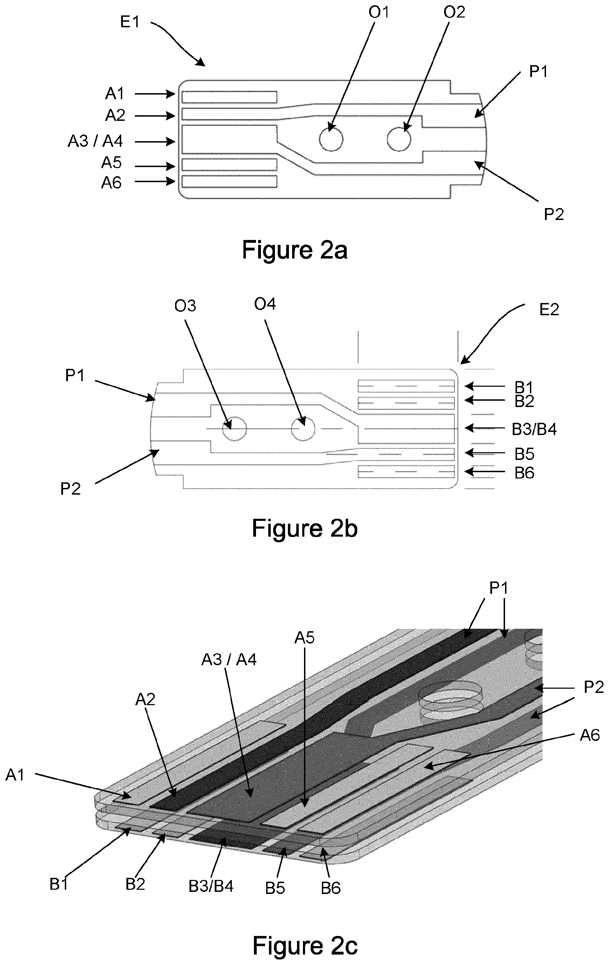

Dans un premier mode de réalisation, décrit en relation avec les figures 2a, 2b et 2c, le circuit imprimé flexible de l'invention comprend deux extrémités, chacune de ces extrémités comprenant de pistes de circuit imprimé comme illustré en figure 2a et 2b. Dans cet exemple, un connecteur « top-down » à six contacts est utilisé. La figure 2a représente une première extrémité (notée E1) d'un circuit imprimé flexible. La figure 2b représente la deuxième extrémité du circuit imprimé flexible de l'invention (notée E2).

Sur la figure 2a, les zones de contacts A1, A2 et A6 ne sont pas utilisés. Les zones de contacts A3 et A4 sont « joints » : la plage de contact permet d'associer la piste P1, qui se rapporte à la première spire, aux zones de contacts A3 et A4 du connecteur. La piste P2 (se rapportant à la deuxième spire), quant à elle, est associée au contact A5 uniquement.

Sur la figure 2b, les zones de contacts B1, B5 et B6 ne sont pas utilisés. Les zones de contacts B3 et B4 sont « joints » : la plage de contact permet d'associer la piste P2, qui se rapporte à la deuxième spire, aux zones de contacts B3 et B4 du connecteur. La piste P1 (se rapportant à la première spire), quant à elle, est associée au contact B2 uniquement. Des orifices (O1, 02, O3, O4) répartis sur l'ensemble du circuit imprimé flexible, permettent de fixer et/ou ajuster le circuit imprimé flexible sur des zones de préhension destinées à cette fonction de préhension, par exemple lors du montage du circuit imprimé flexible sur le dispositif portable.

Sur la figure 2c, une représentation en trois dimensions avec les deux extrémités (E1, E2) jointes, et prêtes à être insérées dans un connecteur. On constate par l'intermédiaire de cette figure 2c, que selon l'invention :
- les zones de contacts A1 et B1 ne sont pas utilisées ;
- les zones de contacts A6 et B6 ne sont pas utilisées ;
- la zone contact A5 est utilisée pour la première piste (P1), qui forme une première spire (S1), la première piste se terminant avec une zone de contact double (B3, B4) ;
- les zones de contacts A3 et A4 sont utilisées conjointement par une piste (P2) débutant avec un contact double et formant la deuxième spire (S2), la deuxième piste (P2) se terminant à la deuxième extrémité au niveau de la zone de contact B5 ;
- la zone de contact A5 n'est pas utilisée.

On remarque ainsi que le changement de spire, dans ce mode de réalisation, est réalisé au niveau des zones de contacts A3-A4 et B3-B4. L'antenne en quelque sorte « débute » à la zone de contact A2, la première spire s'achève aux zones de contacts B3-B4. Une jonction est réalisée, par les contacts des connecteurs (au niveau des contacts correspondants du connecteur) pour connecter les zones de contact B3-B4 avec les zones de contact A3-A4. La deuxième spire débute en A3-A4 et se termine en B5. L'antenne double spire débute en A2 et se termine en B5.

Les avantages procurés par cette solution sont nombreux. En premier lieu, la mise en oeuvre de l'antenne ne nécessite aucune soudure. L'antenne peut comprendre des zones de pliage pour la conformer au volume dans lequel elle doit prendre place. Ces opérations éventuelles de pliage peuvent être manuelles ou automatiques en fonction des modes de réalisation. Le coût de fabrication de l'antenne est donc réduit une première fois. En deuxième lieu, comme l'antenne ne nécessite pas de soudure, il est possible d'employer un matériau flexible de moins grande résistance (il n'y a pas besoin qu'il résiste à la soudure). Ce matériau est donc moins cher et permet de réaliser une deuxième économie. Plus particulièrement, il n'est pas nécessaire d'utiliser le matériau PI (matériau couramment nommé ainsi pour faire référence à du *« Flame-resistant polyimide (PI) film »*) et il est possible de se contenter d'un circuit imprimé flexible monocouche. En troisième lieu, l'antenne peut être facilement mise en oeuvre en se contentant d'enficher les extrémités dans le connecteur.

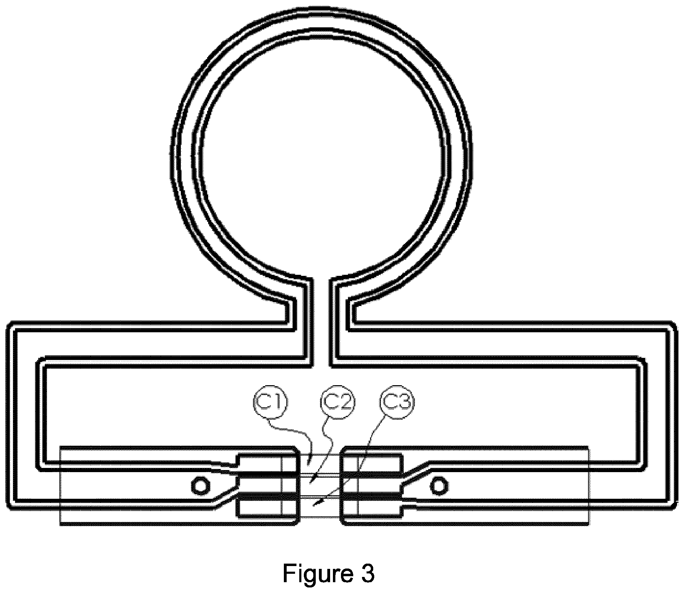

La figure 3 expose un deuxième mode de réalisation de l'antenne selon l'invention, en appliquant le même principe que celui décrit précédemment. Il s'agit à nouveau d'une antenne possédant deux pistes formant deux spires. Dans ce mode de réalisation, l'antenne est préformée (elle n'est pas formée par pliage comme dans le premier mode de réalisation de la figure 1a). Elle comprend, à ses deux extrémités, respectivement deux fois trois plages de connexion. L'antenne débute en C1 et se termine en C3 avec une connexion réalisée en C2, lorsque les deux extrémités du circuit imprimé sont insérées dans le connecteur idoine. Cette solution est sous optimale dans la mesure où le circuit imprimé flexible n'est pas rectiligne, et donc que cette configuration engendre de la perte de matière puisque le découpage de l'antenne nécessite de jeter une partie non négligeable du circuit flexible, alors même que cette partie fait l'objet d'une facturation.

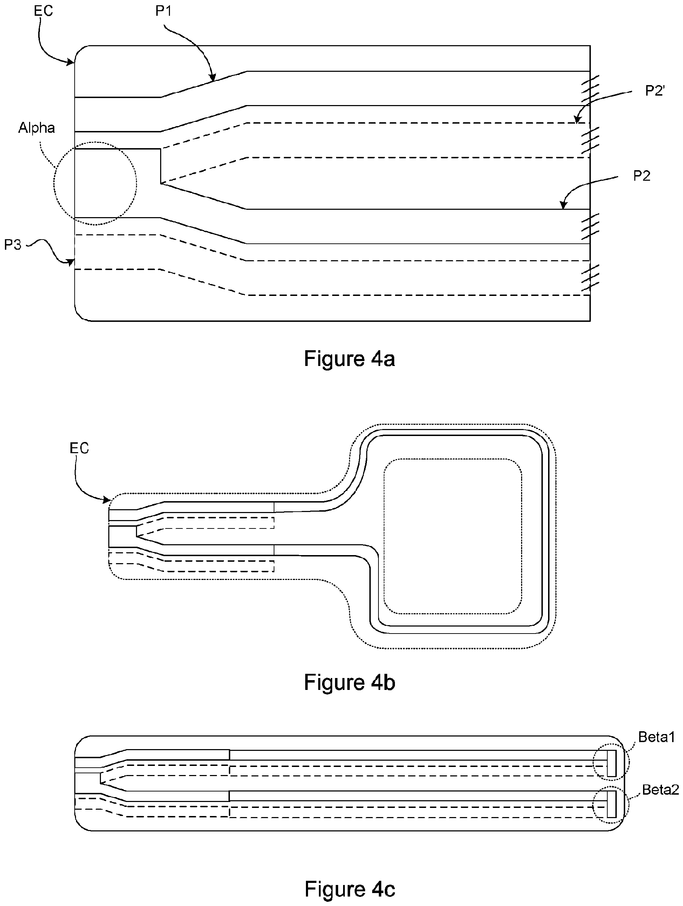

Dans un autre mode de réalisation, le principe général de l'invention est mis en oeuvre sur un circuit imprimé flexible comprenant des pistes imprimées sur les deux faces du circuit imprimé flexible. Ainsi, seule une extrémité du circuit imprimé flexible est insérée dans le connecteur. Un exemple de réalisation d'une antenne selon l'invention est présenté dans les figures 4a, 4b et 4c. Les traits en noir (-) correspondent aux pistes de la face supérieure du circuit imprimé flexible tandis que les traits en pointillé ( - - ) correspondent aux pistes de la face inférieure du circuit imprimé flexible. La figure 4a illustre l'extrémité de connexion (EC). Cette extrémité de connexion (EC) comprend, en face supérieure deux pistes (P1, P2) et en face inférieure également deux pistes (P2' et P3). La jonction entre les deux spires de l'antenne est réalisée au niveau du point de jonction Alpha, lorsque l'extrémité de connexion est insérée dans le connecteur. La figure 4b illustre cette extrémité de connexion (EC) telle qu'implémentable sur une antenne pré formée sur un circuit imprimé flexible. Dans cet exemple, on constate que les pistes (P1 et P2) constituent en réalité une seule et même piste qui parcourt la périphérie de l'antenne. Il en est de même pour P2' et P3 (dont le parcours autour de la périphérie, sur la face inférieure de l'antenne n'est pas représenté). La figure 4c illustre cette extrémité de connexion (EC) telle qu'implémentable sur un circuit imprimé flexible longitudinal, présentant, comme pour la figure 1a, l'avantage supplémentaire de permettre la création d'une circuit imprimé flexible sans perte de matière, pouvant être plié afin de former les spires. Dans cet exemple, des jonctions de connexion (Beta1, Beta2) sont réalisées à la deuxième extrémité du circuit imprimé flexible. Les jonctions de connexion (Beta1, Beta2) sont conformées pour permettre au signal électrique de traverser la ou les couches du circuit imprimé flexible (une continuité de transmission de signal électrique est ainsi réalisée). Comme pour les autres modes de réalisation longitudinaux, l'antenne est d'abord pliée, au niveau de zones de pliage prédéterminée, afin de la conformer au volume dans lequel elle doit prendre place, puis l'extrémité de connexion EC est insérée dans le connecteur.

Dans encore un autre mode de réalisation, comme pour le précédent on enfiche qu'une seule extrémité dans le connecteur. A la différence du précédent, cependant, l'ensemble des pistes du circuit imprimé est dessiné sur la même face du circuit imprimé flexible. L'autre extrémité est collée ou associée (mise en contact) sur une portion prédéterminée du circuit imprimé et une connexion entre les spires est réalisée au niveau de cette portion prédéterminée, plutôt qu'au niveau des deux extrémités. Cette manière de faire modifie quelque peu la manière dont les pistes du circuit imprimé flexible sont dessinées. Le principe cependant consiste toujours à définir des zones de contact particulières destinées à faire jonction entre les pistes lors de l'assemblage (ou du pliage de l'antenne).

D'une manière générale, l'invention est usuellement mise en oeuvre en définissant un circuit imprimé flexible en longueurdans une position dépliée de l'antenne. Ainsi, plutôt que de devoir évider un circuit flexible (et donc de payer pour la partie, centrale, évidée, figures 3 et 4b), le circuit flexible formant une antenne est dessiné en longueur puis replié préalablement ou concomitamment au montage de l'antenne. Le pliage, selon la présente technique peut être un pliage à plat, comme exposé précédemment ou bien un pliage intermédiaire, qui peut alors être considéré comme une déformation plus qu'un réel pliage. On obtient ainsi une antenne dont les caractéristiques sont les mêmes qu'avec un circuit imprimé flexible « évidé », mais avec un cout de réalisation bien inférieur, car justement il n'est pas nécessaire de payer pour la partie évidée du flexible. Par ailleurs, on déduit également les déchets liés à la fabrication de l'antenne. Ainsi, ce simple exemple permet de résoudre les problèmes liés à la fabrication d'une antenne qui doit être positionnée sur le pourtour d'un écran.

## Revendications

1. Circuit imprimé flexible (CIF), comprenant au moins deux pistes conductrices (P1, P2) s'étendant sur la longueur du circuit imprimé flexible, circuit imprimé flexible dans lequel les pistes conductrices forment au moins deux boucles d'antenne, lesdites au moins deux pistes conductrices (P1, P2) étant sensiblement parallèles entre elles, **caractérisé en ce qu'**il comprend au plus deux extrémités (E1, E2), **en ce qu'**il comprend une zone de contact (A3, A4) située à une première extrémité (E1) du circuit imprimé flexible et configurée pour entrer en contact avec une portion prédéterminée dudit circuit imprimé flexible (CIF), de sorte qu'une première piste (P1) du circuit imprimé flexible (CIF) soit connectée avec une deuxième piste (P2) du circuit imprimé flexible (CIF) lorsque la première extrémité (E1) est mise au contact de la portion prédéterminée, et **en ce que** ces deux extrémités (E1) sont configurées de manière à être insérées dans un seul et même connecteur.

2. Circuit imprimé flexible (CIF) selon la revendication 1, **caractérisé en ce que** la portion prédéterminée est constituée de la deuxième extrémité (E2) dudit circuit imprimé.

3. Circuit imprimé flexible (CIF) selon la revendication 2, **caractérisé en ce que** la mise au contact de la première extrémité (E1) avec la deuxième extrémité (E2) est effectuée lors de la connexion des deux extrémités (E1, E2) au sein d'un connecteur.

4. Circuit imprimé flexible (CIF) selon la revendication 1, **caractérisé en ce qu'**il comprend au moins une zone de pliage (Z1, Z2, Z3) conformée pour autoriser le passage dudit circuit imprimé flexible (CIF) d'un état déplié à un état plié.

5. Circuit imprimé flexible (CIF) selon la revendication 1, **caractérisé en ce que** la zone de contact comprend des moyens de connexion des dites au moins deux pistes conductrices entre elles afin de former un nombre prédéfini de boucles d'antenne.

6. Circuit imprimé flexible selon la revendication 1, **caractérisé en ce qu'**il comprend au moins un orifice de fixation (O1, O2, O3, O4) dudit circuit imprimé flexible sur au moins un support d'antenne.

7. Dispositif comprenant des moyens de communication sans fil mettant en oeuvre un émetteur transmetteur et une antenne, dispositif **caractérisé en ce que** ladite antenne comprend un circuit imprimé flexible selon l'une quelconque des revendications 1 à 6.

8. Dispositif, selon la revendication 7, **caractérisé en ce qu'**il comprend un connecteur au sein duquel les deux extrémités du circuit imprimé sont insérées de sorte que la première extrémité est mise au contact de la deuxième extrémité lors de l'insertion des deux extrémités dans ledit connecteur.

9. Dispositif, selon la revendication 8, **caractérisé en ce que** le connecteur est de type top-bottom.

## Patentansprüche

1. Flexible gedruckte Schaltung (CIF), aufweisend mindestens zwei Leiterbahnen (P1, P2), die sich über die Länge der flexiblen gedruckten Schaltung erstrecken, wobei die Leiterbahnen mindestens zwei Antennenschleifen bilden, wobei die mindestens zwei Leiterbahnen (P1, P2) im Wesentlichen parallel zueinander sind, **dadurch gekennzeichnet,**
**dass** sie höchstens zwei Enden (E1, E2) aufweist,
**dass** sie einen Kontaktbereich (A3, A4) aufweist, der sich an einem ersten Ende (E1) der flexiblen Schaltung befindet und so konfiguriert ist, dass er mit einem vorbestimmten Bereich der flexiblen Schaltung (CIF) in Kontakt kommt, so dass eine erste Spur (P1) der flexiblen gedruckten Schaltung (CIF) mit einer zweiten Spur (P2) der flexiblen gedruckten Schaltung (CIF) verbunden wird, wenn das erste Ende (E1) mit dem vorbestimmten Bereich in Kontakt gebracht wird, und
**dass** diese beiden Enden (E1) so konfiguriert sind, dass sie in ein und denselben Verbinder eingesetzt werden können.

2. Flexible gedruckte Schaltung (CIF) nach Anspruch 1, **dadurch gekennzeichnet, dass** der vorbestimmte Bereich aus dem zweiten Ende (E2) der gedruckten Schaltung besteht.

3. Flexible gedruckte Schaltung (FPC) nach Anspruch 2, **dadurch gekennzeichnet, dass** die Kontaktierung des ersten Endes (E1) mit dem zweiten Ende (E2) bei der Verbindung der beiden Enden (E1, E2) innerhalb eines Verbinders erfolgt.

4. Flexible gedruckte Schaltung (CIF) nach Anspruch 1, **dadurch gekennzeichnet, dass** sie mindestens eine Biegezone (Z1, Z2, Z3) aufweist, die so geformt ist, dass sie den Übergang der flexiblen gedruckten Schaltung (CIF) von einem entfalteten Zustand in einen gefalteten Zustand zulässt.

5. Flexible gedruckte Schaltung (FPC) nach Anspruch 1, **dadurch gekennzeichnet, dass** der Kontaktbereich Mittel zum Verbinden der mindestens zwei Leiterbahnen miteinander aufweist, um eine vordefinierte Anzahl von Antennenschleifen zu bilden.

6. Flexible gedruckte Schaltung nach Anspruch 1, **dadurch gekennzeichnet, dass** sie mindestens eine Öffnung (O1, O2, O3, O4) zur Befestigung der flexiblen gedruckten Schaltung an mindestens einem Antennenträger aufweist.

7. Vorrichtung aufweisend drahtlose Kommunikationsmittel, die einen Sender und eine Antenne einsetzen, wobei die Vorrichtung **dadurch gekennzeichnet ist, dass** die Antenne eine flexible gedruckte Schaltung nach einem der Ansprüche 1 bis 6 aufweist.

8. Vorrichtung, nach Anspruch 7, **dadurch gekennzeichnet, dass** sie einen Verbinder aufweist, in den die beiden Enden der gedruckten Schaltung so eingeführt werden, dass das erste Ende mit dem zweiten Ende in Kontakt gebracht wird, wenn die beiden Enden in den Verbinder eingeführt werden.

9. Vorrichtung, nach Anspruch 8, **dadurch gekennzeichnet, dass** der Verbinder vom Top-Bottom-Typ ist.

## Claims

1. Flexible printed circuit board (CIF), comprising at least two conductive tracks (P1, P2) extending along the length of the flexible printed circuit board, flexible printed circuit in which the conductive tracks form at least two antenna loops, said at least two conductive tracks (PI, P2) being substantially parallel to each other, **characterized in that** it comprises not more than two ends (E1, E2), **in that** it comprises a contact area (A3, A4) located at a first end (E1) of the flexible printed circuit board and configured to come into contact with a predetermined portion of said flexible printed circuit board (CIF), such that a first track (P1) of the flexible printed circuit board (CIF) is connected with a second track (P2) of the flexible printed circuit board (CIF) when the first end (E1) is brought into contact with the predetermined portion, and **in that** these two ends (E1) are configured in a manner to be inserted into one and the same connector.

2. Flexible printed circuit board (CIF) according to claim 1, **characterised in that** the predetermined portion consists of the second end (E2) of said printed circuit board.

3. Flexible printed circuit board (CIF) according to claim 2, **characterised in that** the contact of the first end (E1) with the second end (E2) is performed when the two ends (E1, E2) are connected within a connector.

4. Flexible printed circuit board (FIC) according to claim 1, **characterised in that** it comprises at least one phage area (Z1, Z2, Z3) conformed to allow said flexible printed circuit board (FIC) to be changed from an unfolded to a folded state.

5. Flexible printed circuit board (CIF) according to claim 1, **characterised in that** the contact area means of connecting said at least two conductive tracks to each other in order to form a predefined number of antenna loops.

6. Flexible printed circuit board according to claim 1, **characterised in that** it comprises at least one mounting hole (O1, O2, O3, O4) of said flexible printed circuit board on at least one antenna support.

7. Device comprising wireless means of communication using a transceiver and an antenna, **characterised in that** said antenna comprises a flexible printed circuit board according to any one of claims 1 to 6.

8. Device, according to claim 7, **characterised in that** it comprises a connector within which the two ends of the printed circuit board are inserted so that the first end is brought into contact with the second end when inserting the two ends into said connector.

9. Device according to claim 8, **characterised in that** the connector is of the top-bottom type.
